# EUROPÄISCHE PATENTSCHRIFT

(11) **EP 0 875 767 B1**
(45) Veröffentlichungstag und Bekanntmachung des Hinweises auf die Patenterteilung: **08.08.2007**
(21) Anmeldenummer: 97118639.0
(22) Anmeldetag: 27.10.1997
(51) Int. Cl.: G01R 31/28

(54) **Vorrichtung und Verfahren zum Prüfen von unbestückten Leiterplatten**
Device and procedure for testing naked circuit boards
Appareil et procédé pour tester des circuits imprimés non pourvus de composants

(30) Priorität: 02.05.1997 DE 19718637
(43) Veröffentlichungstag der Anmeldung: 04.11.1998
(73) Patentinhaber: atg test systems GmbH, 97877 Wertheim/Reicholzheim (DE)
(72) Erfinder: Prokopp, Manfred, 97877 Wertheim-Reicholzheim (DE)
(74) Vertreter: Ganahl, Bernhard

(56) Entgegenhaltungen:
- EP-A- 0 636 895
- WO-A-95/23341
- DE-A- 19 507 127
- FR-A- 2 608 775

## Beschreibung

Die Erfindung betrifft eine Vorrichtung und ein Verfahren zum Prüfen von unbestückten Leiterplatten.

Leiterplatten weisen eine Vielzahl von Netzen auf, wobei deren Dichte auf den Leiterplatten sich mit der kontinuierlich fortschreitenden Miniaturisierung der elektronischen Bauelemente zunehmend erhöht.

Bekannte Vorrichtungen zum Prüfen von Leiterplatten können grundsätzlich in zwei Gruppen eingeteilt werden. Zur ersten Gruppe gehören die sogenannten Paralleltester, das sind Prüfvorrichtungen mit Adapter, bei welchen alle Leiterplattentestpunkte einer Leiterplatte gleichzeitig mittels des Adapters kontaktiert werden. Die zweite Gruppe umfaßt die sogenannten Fingertester. Das sind Vorrichtungen, die mit zwei oder mehreren Prüffingern die einzelnen Leiterplattentestpunkte sequentiell abtasten.

Prüfvorrichtungen mit Adapter gehen bspw. aus der DE 42 37 591 A1, der DE 44 06 538 A1, der DE 43 23 276 A1, der EP 215 146 B1 und der DE 38 38 413 A1 hervor.

Derartige Adapter dienen grundsätzlich dazu, die ungleichmäßige Konfiguration der Leiterplattentestpunkte der zu testenden Leiterplatte an das vorgegebene Grundraster der elektrischen Prüfvorrichtung anzupassen. Bei modernen, zu testenden Leiterplatten sind die Leiterplattentestpunkte nicht mehr in einem gleichmäßigen Raster angeordnet, weshalb die die Verbindung zwischen dem Kontaktraster und den Leiterplattentestpunkten herstellenden Kontaktnadeln im Adapter mit einer Schrägstellung bzw. Auslenkung angeordnet sind oder ein sogenannter Translator vorgesehen ist, der das gleichmäßige Kontaktraster in die ungleichmäßige Konfiguration der Leiterplattentestpunkte "übersetzt".

Unabhängig von der Art der Vorrichtung werden die einzelnen Netze auf Unterbrechungen in den Netzen ("Unterbrechungstest") und auf elektrische Verbindungen zu anderen Netzen ("Kurzschlußtest") getestet. Der Kurzschlußtest kann sowohl die Detektion von niederohmigen als auch von hochohmigen Verbindungen umfassen.

Sowohl für den Unterbrechungstest als auch für den Kurzschlußtest sind unterschiedliche Meßverfahren bekannt. Hierbei wird jedes Netz auf einen Kurzschluß bzw. jeder Zweig eines Netzes auf eine Unterbrechung untersucht, so daß bei modernen Leiterplatten mit einer Vielzahl von Netzen eine entsprechend hohe Anzahl einzelner Meßvorgänge durchgeführt werden muß.

Man hat versucht, die einzelnen Meßvorgänge zu optimieren und deren Anzahl zu minimieren, wobei eine Vielzahl unterschiedlicher Verfahren vorgeschlagen und umgesetzt worden sind.

Ferner sind Vorrichtungen zum Prüfen von bestückten Leiterplatten bekannt (z.B. WO96/27136 bzw. DE 195 07 127). Der Test von bestückten Leiterplatten unterscheidet sich grundlegend von dem für unbestückte Leiterplatten, da bei bestückten Leiterplatten ein sogenannter Funktionstest ausgeführt werden kann. Dies bedeutet, daß ein jedes Netz der Leiterplatte in der Regel nur an einer einzigen Stelle kontaktiert wird und ein sich in Abhängigkeit von vorbestimmten Spannungen oder Strömen einstellender Spannungs- oder Stromwert gemessen wird. Dies ist möglich, da bei bestückten Leiterplatten alle Funktionselemente (ICs, Transistoren, Widerstände, Kondensatoren, usw.) vorhanden sind und deren Funktion getestet werden kann. Die Anzahl der Kontaktierungen zwischen der Prüfvorrichtung und der zu prüfenden Leiterplatte ist deshalb beim Test von bestückten Leiterplatten wesentlich geringer als beim Test von unbestückten Leiterplatten. Herkömmliche Vorrichtungen zum Prüfen von bestückten Leiterplatten weisen zur Durchführung der Funktionstest Adapter auf, deren Prüfstifte aufwendig verdrahtet sind. Gegenüber solchen Prüfvorrichtungen sieht die WO 96/27136 ein Adaptersystem mit einer Rasterplatte vor, an welcher mehrere Kontaktflächen miteinander über Testkanäle elektrisch verbunden sind, wobei die Kontaktflächen vermischt verteilt auf der Rasterplatte positioniert sind. Das Rastermaß der Rasterplatte beträgt üblicherweise 1,27 mm. Die Verdrahtung wird somit in die Rasterplatte integriert. Eine solche Vorrichtung ist zum Prüfen von unbestückten Leiterplatten, die mit einer viel höheren Kontaktdichte kontaktiert werden müssen, ungeeignet.

Aus der WO95/23341 geht eine Vorrichtung zum Testen von Leiterplatten hervor, die ein sogenanntes "High Density Test Point Expansion Module" aufweist, mit dem lokal die zur Verfügung stehende Dichte an Kontaktpunkten wesentlich erhöht werden kann. Gemäß einer weiteren Ausführungsform wird mittels eines "Translator Module" eine in einem vorbestimmten Bereich erhöhte Dichte von Kontaktstellen geschaffen, wobei innerhalb des Translators Leiterbahnen vorgesehen sind, die Kontaktstellen im Raster des Grundrasters mit anderen Kontaktstellen auf der anderen Seite des Translators verbinden, die mit einer höheren Dichte angeordnet sind. Diese Vorrichtung ist zum Testen von kleinen Leiterplatten in der Größe von Kreditkarten geeignet.

Die EP 0 448 483 A1 offenbart eine Vorrichtung zum Prüfen von Leiterplatten, die eine Zwischenstruktur aufweist, mit welcher sehr eng benachbarte Leiterplattentestpunkte in ein vorbestimmtes Raster von Kontaktstellen umgesetzt werden, die einem regelmäßigen Raster angeordnet sind. Die im regelmäßigen Raster angeordneten Kontaktstellen können einfach von der Prüfvorrichtung kontaktiert werden.

Die US 4,774,462 offenbart einen Paralleltester zum Testen von sowohl bestückten als auch unbestückten Leiterplatten. Dieser Paralleltester ist zum Testen von Leierplatten ausgebildet, deren Kontaktstellen in einem Raster von 0,1 Zoll angeordnet sind. Diese Testvorrichtung ist auch lediglich zum einseitigen Testen der Leiterplatten ausgebildet. Diese Prüfvorrichtung weist ein Grundraster mit 50 Kontaktstellen pro Quadratzoll auf, wobei die Kontaktstellen paarweise miteinander elektrisch verbunden sind. Die Verbindung zwischen den Kontaktstellen untereinander und von den Kontaktstellen zu Auswerteelektronik erfolgt mittels von Hand verlegter Leitungen. Auf diesem Grundraster ist ein Adapter mit schräg gestellten Federkontaktstiften angeordnet.

Der Erfindung liegt die Aufgabe zugrunde, eine einfach ausgebildete Vorrichtung zum Prüfen von unbestückten Leiterplatten zu schaffen, mit der Leiterplatten mit einer hohen Leiterplattentestpunktdichte und/oder sehr kleinen Abständen zwischen den Leiterplattentestpunkten getestet werden können.

Die Aufgabe wird durch eine Vorrichtung mit den Merkmalen des Anspruchs 1 gelöst.

Vorteilhafte Ausgestaltungen der Erfindung sind in den Unteransprüchen angegeben.

Die Erfindung wird beispielhaft anhand der Zeichnungen näher erläutert. Es zeigen:
- Fig. 1: schematisch vereinfacht ein Grundraster in der Draufsicht,
- Fig. 2: eine Grundrasterplatte im Querschnitt im Bereich zweier Scankanäle,
- Fig. 3a bis 3c: jeweils schematisch sehr vereinfacht eine Anordnung einer zu prüfenden Leiterplatte auf einer Grundrasterplatte,
- Fig. 4a: einen Pintranslatoradapter im Querschnitt,
- Fig. 4b: schematisch die Leiterbahnen eines Translators in der Draufsicht,
- Fig. 5: schematisch vereinfacht ein weiteres Grundraster in der Draufsicht,
- Fig. 6: schematisch eine erfindungsgemäße Prüfvorrichtung im Querschnitt.

Die Prüfvorrichtung weist eine Auswerteelektronik auf, welche elektrisch mit einem Grundraster verbunden ist. Auf dem Grundraster lagert ein Adapter. Auf den Adapter wird eine zu prüfende Leiterplatte aufgelegt, wobei der Adapter einen elektrischen Kontakt zwischen den auf der Leiterplatte befindlichen Leiterplattentestpunkten und jeweils einer Kontaktstelle bzw. einem Padfeld des Grundrasters herstellt. In den Adapter kann ein Translatorboard eingesetzt sein, mit welchem die elektrischen Verbindungen von einer Kontaktstelle zu einem davon entfernt angeordneten Leiterplattentestpunkt der Leiterplatte umgeleitet werden können.

Die erfindungsgemäße Vorrichtung weist ein Grundrasterfeld 1 mit mehreren Kontaktstellen 2 auf, die auf einer Grundrasterplatte 3 ausgebildet sind. Es sind zumindest zwei Kontaktstellen 2 des Grundrasterfeldes 1 in der Grundrasterplatte 3 elektrisch verbunden.

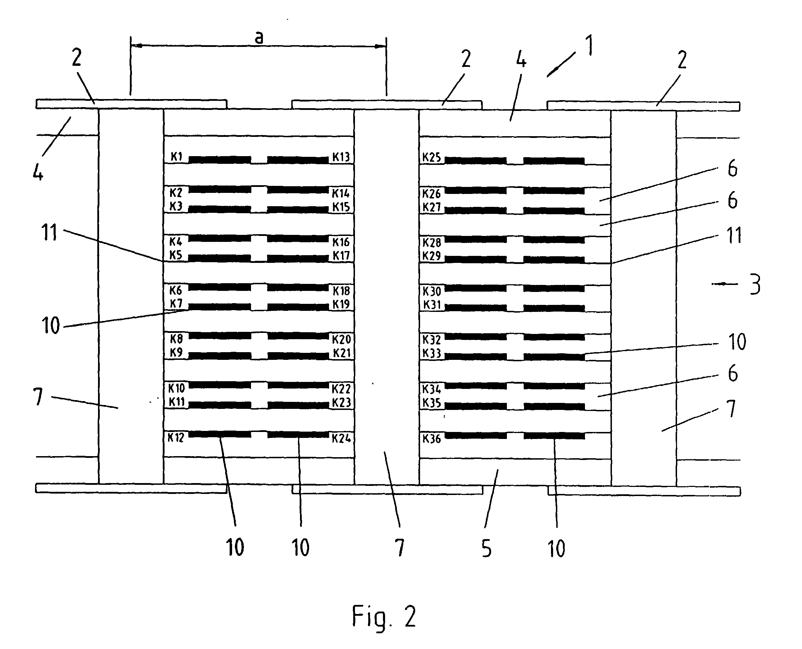

Die Grundrasterplatte 3 ist vorzugsweise aus einer laminierten Leiterplatte ausgebildet. Das in Fig. 2 abgebildete Ausführungsbeispiel weist eine obere und eine untere Begrenzungslage 4, 5 und dreizehn Zwischenlagen 6 auf.

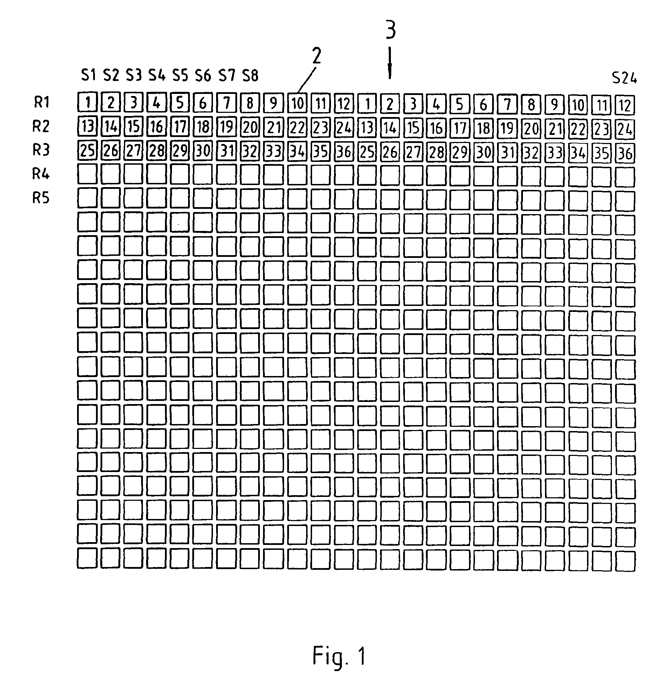

Von den Kontaktstellen 2 erstreckt sich senkrecht durch die oberste Lage 4 und alle Zwischenlagen 6 jeweils eine vertikale Durchkontaktierung 7. Die Durchkontaktierungen 7 sind in der Regel als Bohrungen mit einer leitenden, metallisierten Beschichtung ausgebildet. Die Durchkontaktierungen 7 sind bspw. in einem regelmäßigen quadratischen Raster angeordnet, wobei der Mittenabstand a zwischen zwei Durchkontaktierungen 7 bspw. 500 µm beträgt. Bei keramischen Grundrasterplatten 3 kann der Mittenabstand a bis auf 100 µm verringert werden. Es sind auch andere Arten einer regelmäßigen Rasterung möglich, wie z.B. ein rechteckiges oder hexagonales Raster oder auch ein Raster, bei welchem die Durchkontaktierungen 7 benachbarter Reihen zueinander versetzt angeordnet sind. Die Durchkontaktierungen 7 und die entsprechenden Kontaktstellen 2 sind somit in Reihen (R1, R2, ...) und Spalten (S1, S2, ...) angeordnet (Fig. 1). Zwischen zwei Reihen von Durchkontaktierungen 7 sind jeweils Leiterbahnen 10 in der Grundrasterplatte 3 eingebettet, die nachfolgend als Scankanäle bezeichnet werden. Bei dem in den Fig. 1 dargestellten Ausführungsbeispiel sind zwischen zwei Reihen von Durchkontaktierungen 7 jeweils zwölf und bei dem in Fig. 2 dargestellten Ausführungsbeispiel jeweils vierundzwanzig Scankanäle 10 vorgesehen, die jeweils paarweise in einer Zwischenschicht zwischen zwei Zwischenlagen 6 angeordnet sind. Die jeweils zwölf Paare benachbart zu einer Reihe von Durchkontaktierungen 7 angeordneten Scankanäle 10 sind dieser Reihe zugeordnet, d.h., daß jede Durchkontaktierung 7 und damit jede Kontaktstelle 2 einer bestimmten Reihe elektrisch mit einem der dieser Reihe zugeordneten Scankanäle 10 über eine Stichleitung 11 verbunden ist.

In Fig. 2 sind 36 Kanäle mit K1 bis K36 bezeichnet, wobei in Fig. 1 in die Kontaktstellen 2 der ersten drei Reihen die Nummern der Kanäle eingetragen sind, mit welchen sie elektrisch verbunden sind. Gemäß Fig. 1 sind in einer Reihe jede zwölfte Kontaktstelle 2 mit dem gleichen Scankanal 10 elektrisch verbunden ist. Man spricht deshalb von einer Wiederholungsfolge von zwölf. Mit anderen Worten heißt dies, daß jede zwölfte Kontaktstelle 2 einer Reihe über einen Scankanal 10 elektrisch verbunden ist. Es werden somit eine Anzahl von Kontaktstellen 2 jeweils mit einem Scankanal 10 erfaßt. Hierdurch vereinfacht sich die Leiterbahnenstruktur in der Grundrasterplatte 3 wesentlich, so daß die Durchkontaktierungen 7 mit einem viel geringeren Abstand als bei herkömmlichen Grundrasterplatten angeordnet werden können, wodurch die Rasterdichte der Kontaktstellen wesentlich erhöht werden kann.

Die Scankanäle 10 sind an den Rändern der Grundrasterplatte 3 an elektrische Verbinder wie. z.B. Steckverbinder angeschlossen, an welche die Scan- bzw. Auswerteelektronik angeschlossen werden kann. Trotz einer Vielzahl von Kontaktstellen 2 auf dem Grundrasterfeld 1 ist die Anzahl der Testanschlüsse der Auswerteelektronik relativ gering, da lediglich für einen jeden Scankanal ein Testanschluß vorgesehen werden muß. Bei bekannten Prüfvorrichtungen ist für jede Kontaktstelle ein eigener Testanschluß zur Auswerteelektronik vorgesehen. Gegenüber diesen bekannten Prüfvorrichtungen vermindert sich die Auswerteelektronik erheblich, nämlich in exakt dem Maße, mit welchem die Kontaktstellen an den Scankanälen zusammengefaßt und die Testanschlüsse verringert werden.

Anstatt eines Steckverbinders kann jede geeignete lösbare und nicht lösbare elektrische Verbindung an der Schnittstelle zwischen der Grundrasterplatte 3 und der Auswerteelektronik vorgesehen werden. Bspw. können die Testanschlüsse an die Scankanäle angelötet sein. Eine solche unlösbare elektrische Verbindung ist vor allem dann geeignet, wenn die Auswerteelektronik in die Grundrasterplatte 3 integriert bzw. unterhalb an die Grundrasterplatte 3 an diese anliegend befestigt wird.

Der mechanische Aufbau der erfindungsgemäßen Vorrichtung ist zudem sehr einfach, da die elektrischen Anschlüsse seitlich an der Grundrasterplatte 3 angeordnet sind, so daß die Elektronik räumlich getrennt von der Grundrasterplatte 3 angeordnet werden kann. Somit können unmittelbar unter der Grundrasterplatte Druckelemente, wie z.B. eine Druckplatte, angeordnet sein, mit welcher die Grundrasterplatte 3 und ein Adapter und/oder ein Translator gegen die zu prüfende Leiterplatte gedrückt werden.

Grundsätzlich ist es möglich, daß durch die elektrische Verbindung der Kontaktstellen einzelne Netze der zu prüfenden Leiterplatte elektrisch verbunden werden, so daß eine für sog. Paralleltester (= Prüvorrichtung mit Adapter) herkömmliche Unterbrechungs- bzw. Kurzschlußmessung nicht möglich wäre.

Es hat sich überraschenderweise gezeigt, daß bei einem Großteil der zu testenden Leiterplatten dieses Problem nicht auftritt, da die Leiterplatten sogenannte Leiterplattentestpunktnester aufweisen, in welchen die Leiterplattentestpunkte in hoher Dichte eng beieinander liegend angeordnet sind, wohingegen die übrigen Leiterplattentestpunkte mit größerem Abstand verteilt auf der Leiterplatte angeordnet sind. Nur im Bereich der Leiterplattentestpunktnester wird die überwiegende Anzahl von Kontaktstellen 2 des Grundrasters 1 kontaktiert, wohingegen die meisten übrigen Kontaktstellen nicht benutzt werden. Deshalb können durch eine geschickte Anordnung der Leiterplatte auf der Prüfvorrichtung derartige unerwünschten elektrischen Verbindungen bzw. Kurzschlüsse vermieden werden.

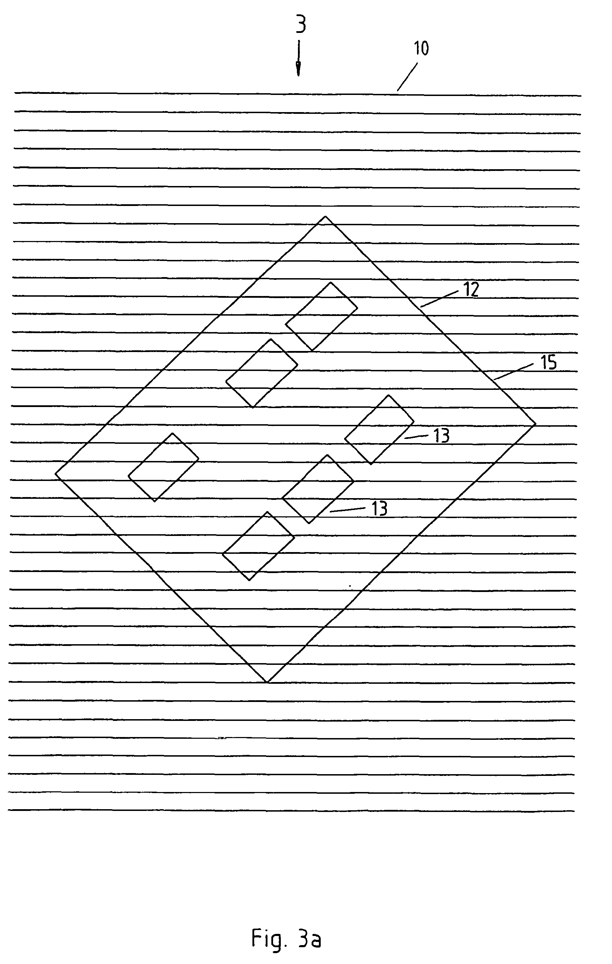

In den Fig. 3a bis 3c sind schematisch vereinfacht derartige Anordnungen dargestellt, wobei sich die Darstellung lediglich auf die Kontur der zu testenden Leiterplatte 12, deren Leiterplattentestpunktnester 13 und den Verlauf der Scankanäle 10 beschränkt. Gemäß Fig. 3a ist die rechteckförmige Leiterplatte 12 mit ihren Seitenkanten 15 schräg zu den Scankanälen 10 angeordnet. Die Leiterplattentestpunktnester 13 sind auf der Leiterplatte 12 üblicherweise entlang parallel zu den Seitenkanten 15 verlaufenden Reihen angeordnet, so daß durch die Schrägstellung verhindert werden kann, daß mehrere Leiterplattentestpunktnester über den gleichen Scankanälen 10 angeordnet sind. Hierdurch wird die Wahrscheinlichkeit deutlich verringert, daß ein Scankanal mit mehreren Leiterplattentestpunkten der zu testenden Leiterplatte 12 kontaktiert wird.

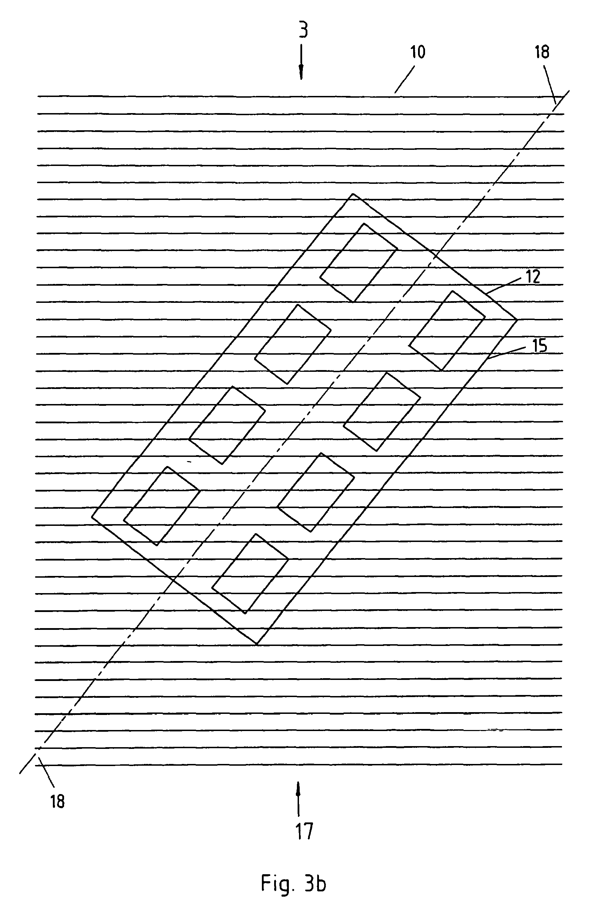

In Fig. 3b ist eine Grundrasterplatte 3 dargestellt, deren Scankanäle 10 sich nicht über die gesamte Breite oder Länge der Grundrasterplatte 3 erstrecken, sondern in zwei voneinander getrennte Bereiche 16, 17 längs einer diagonal auf der Grundrasterplatte 3 verlaufenden Trennlinie 18 geteilt sind. Die beiden Bereiche 16, 17 sind elektrisch voneinander vollkommen entkoppelt, so daß keine die Trennlinie 18 kreuzende elektrische Verbindung über die Scankanäle 10 auftreten kann.

Vorzugsweise ist die Grundrasterplatte 3 auch mechanisch in die beiden Bereiche 16, 17 aufgeteilt. Die mechanische Trennlinie muß nicht zwischen den elektrisch entkoppelten Bereichen 16, 17 verlaufen, sondern kann auch zwischen zwei beliebigen Scankanälen 10 angeordnet sein.

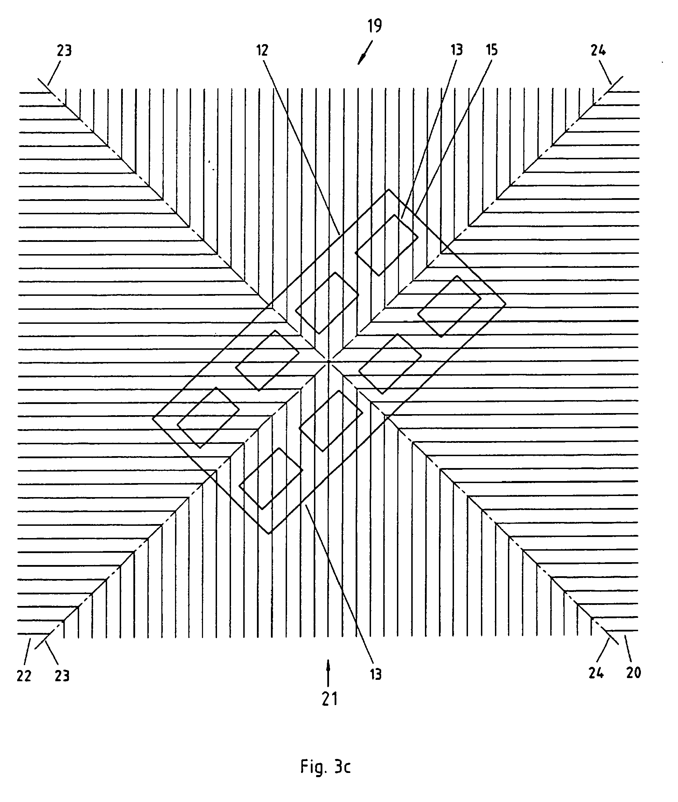

Die Grundrasterplatte kann auch in mehrere voneinander entkoppelte Bereiche 19, 20, 21, 22 elektrisch und/oder mechanisch aufgeteilt sein (Fig. 3c), wobei die Trennlinien 23, 24 vorzugsweise diagonal auf der Grundrasterplatte 3 angeordnet sind.

Dem Problem der unerwünschten elektrischen Verbindungen kann auch bereits beim Bau der Adapter entgegengetreten werden, die zwischen dem Grundraster und der zu prüfenden Leiterplatte angeordnet sind, wobei der Adapter so auf dem Grundraster angeordnet wird und die Zuordnung der Kontaktstellen des Grundrasters zu den Netzen der zu prüfenden Leiterplatte so gewählt wird, daß unerwünschte elektrische Verbindungen nicht auftreten. Dies ist oftmals möglich, da in der Regel viele Kontaktstellen des Grundrasters nicht benutzt werden und lediglich die Kontaktstellen im Bereich der Leiterplattentestpunktnester intensiv benutzt werden.

Adapter weisen in der Regel Nadeln auf, die einen elektrischen Kontakt zwischen den Kontaktstellen 2 und den Leiterplattentestpunkten der zu prüfenden Leiterplatte bzw. einem dazwischen angeordneten Translator herstellen. Durch eine geringe Schrägstellung der Nadeln kann die Verbindung von einem Leiterplattentestpunkt der Leiterplatte zu einer nicht unmittelbar senkrecht unter dem Leiterplattentestpunkt angeordneten Kontaktstelle 2 des Grundrasters 1 hergestellt werden. Da auf dem erfindungsgemäßen Grundraster 1 die Kontaktstellen 2 sehr dicht nebeneinander angeordnet sind, kann ohne weiteres mit einer einzigen Nadel ein Bereich von z.B. 16 Kontaktstellen 2 angesprochen wedren. Hierdurch kann gezielt eine Kontaktstelle 2 aus einer Gruppe von dicht nebeneinander angeordneten Kontaktstellen 2 ausgewählt werden, wodurch ebenfalls ein entsprechender Scankanal 10 gewählt wird. Somit können durch die Ausgestaltung des Adapters unerwünschte elektrische Verbindungen bzw. Kurzschlüsse gezielt ausgeschlossen werden.

Mit den oben angegebenen Möglichkeiten zur Verminderung der Wahrscheinlichkeit, daß eine unerwünschte elektrische Verbindung zwischen zwei Netzen auftritt, kann im Idealfall erreicht werden, daß jeder Scankanal mit höchstens einem einzigen Leiterplattentestpunkt elektrisch verbunden ist, da das erfindungsgemäße Grundraster eine außergewöhnlich hohe Kontaktstellendichte aufweist, so daß lokal zwischen mehreren Kontaktstellen bzw. mehreren Scankanälen ausgewählt werden kann.

Es hat sich überraschenderweise gezeigt, daß bei einem Mittenabstand der Kontaktstellen 2 von 630 µm und einer Auslenkung der Prüfnadeln von vier Kontaktstellen in einer Richtung (= 16 Kontaktstellen in der Fläche) und einer Wiederholungsfolge von 32, d.h. jede 32. Kontaktstelle 2 einer Reihe ist mit dem gleichen Scankanal 10 elektrisch verbunden, mehr als 98% aller Leiterplattentypen mit bis zu 15.000 Leiterplattentestpunkten ohne Doppelbelegung eines Scankanals an der Prüfvorrichtung angeordnet werden können. Insbesondere ist überraschend, daß die meisten Leiterplatten, vor allem fast alle mit bis etwa 10.000 Leiterplattentestpunkte, in einer bzgl. der Prüfvorrichtung vorbestimmten Anordnung, nämlich der, in der sie bereits mit herkömmlichen Prüfvorrichtungen geprüft werden, ohne Doppelbelegung der Scankanäle aufgelöst werden können. Bei automatisierten Prüfvorrichtungen sind in dieser Anordnung in der Regel die Leiterplatten mit ihrer Längsrichtung in Transportrichtung der automatisierten Prüfvorrichtung ausgerichtet.

Dieses Ergebnis bedeutet, daß herkömmliche Leiterplatten mit einer erfindungsgemäßen Vorrichtung mit wesentlich weniger Einheiten der Auswerteelektronik getestet werden können, wodurch sich die Kosten für eine solche Prüfvorrichtung deutlich verringern. Zudem können zukünftige Leiterplatten, die eine höhere Dichte an Leiterplattentestpunkten, insbesondere im Bereich von Leiterplattentestpunktnestern, aufweisen, mit der erfindungsgemäßen Prüfvorrichtung zum Prüfen unbestückter Leiterplatten getestet werden.

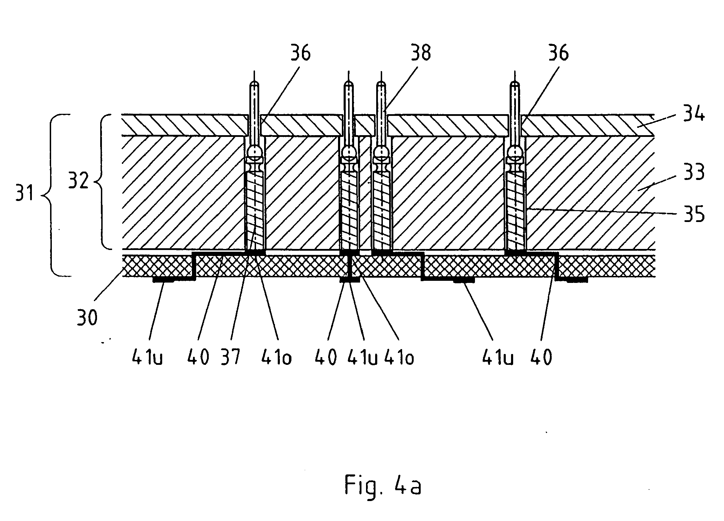

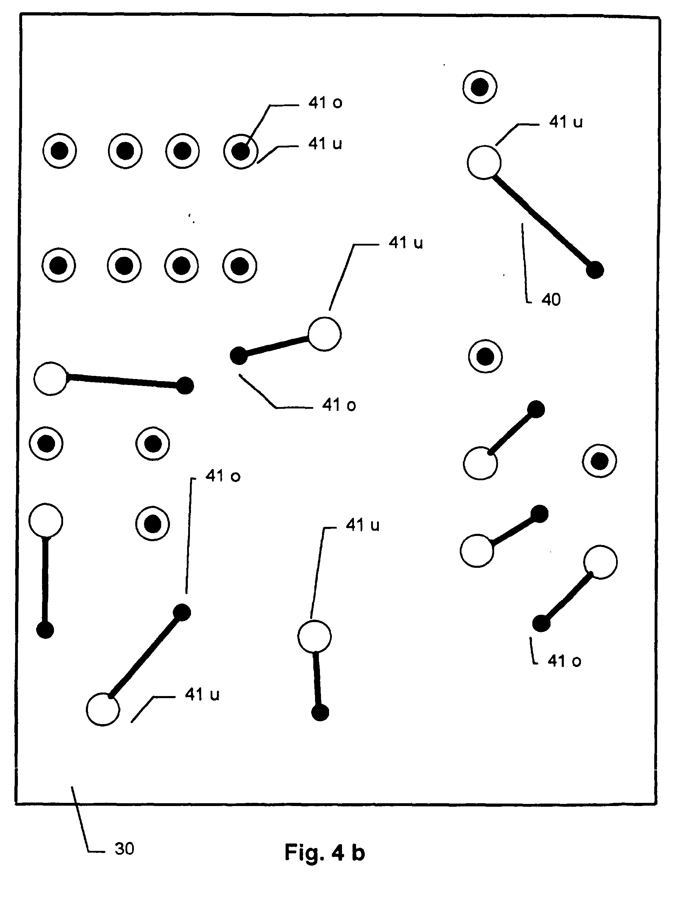

Sollten sich durch die Schrägstellung der Nadeln nicht alle unerwünschten elektrischen Verbindungen beseitigen lassen, kann auch in Kombination mit oder alternativ zu einem Adapter mit schräggestellten Nadeln ein Translator bzw. ein Translatorboard 30 (Fig. 4a, 4b) verwendet werden. Ein Translatorboard 30 kann in einen sogenannten Translatoradapter 31 integriert sein, der aus dem Translatorboard 30 und einem Pintranslatoradapter 32 besteht. Der Pintranslatoradapter 32 ist aus zwei Lagen 33, 34 ausgebildet, die jeweils mit vertikalen Bohrungen 35, 36 im gleichen Bohrmuster durchsetzt sind, so daß die Bohrungen 35, 36 paarweise zueinander fluchten. In der unteren Lage 33 ist in den Bohrungen 35 jeweils ein stiftförmiges Kontaktfederelement 37 angeordnet. Am oberen Ende der Kontaktfederelemente 37 ist jeweils ein Pin 38 angeordnet, der sich durch eine Bohrung 36 erstreckt und am Pintranslatoradapter 32 mit seinem oberen Endbereich vorsteht. Die Pins 38 sind auf den Kontaktfederelementen 37 vertikal nachgebend gelagert.

Anstelle eines Pintranslatoradapters 32 mit den Kontaktfederelementen 37 und den Pins 38 kann der Translatoradapter 31 auch einen Adapter mit schräggestellten Glattnadeln, Biegenadeln oder elektrisch leitenden Gumminoppen oder einem anderen geeigneten elektrischen Verbindungsmittel aufweisen.

Das Translatorboard 30 ist unterhalb des Pintranslatoradapters 32 angeordnet. Es ist aus einer Leiterplatte 39 mit sich von seiner Oberseite zu seiner Unterseite erstreckenden Leiterbahnen 40 ausgebildet. An den Endpunkten der Leiterbahnen 40 auf der Ober- bzw. Unterseite des Translatorboards ist jeweils eine Kontaktfläche 41o, 41u ausgebildet. Die Kontaktflächen 41u an der Unterseite des Translatorboards 30 werden über einen an sich bekannten Vollrasteradapter mit den Kontaktstellen 2 des Grundrasterfeldes 1 verbunden.

Das erfindungsgemäße Translatorboard weist im wesentlichen das Translatorboard vertikal durchsetzende Leiterbahnen 40 auf, lediglich die Leiterplattentestpunkte, die in unerwünschter Weise über die Scankanäle elektrisch verbunden werden würden, werden im Translatorboard zu einer anderen Kontaktstelle 2 umgeleitet (= "gerootet"), so daß die unerwünschten elektrischen Verbindungen, z.B. eine doppelte Belegung eines Scankanals, vermieden werden. In Fig. 4b sind die oberen Kontaktflächen 410 durch einen Punkt und die unteren Kontaktflächen 41u durch einen Ring dargestellt.

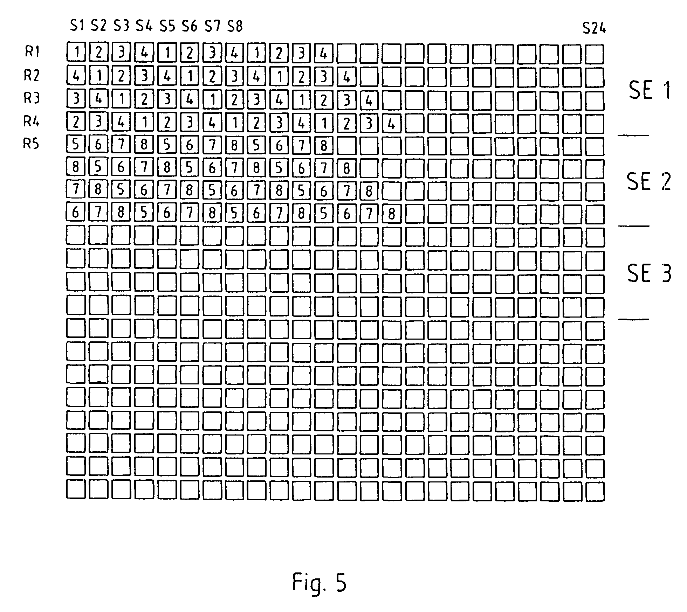

In Fig. 5 ist ein weiteres Ausführungsbeispiel eines erfindungsgemäßen Grundrasterfeldes dargestellt. Dieses Grundrasterfeld ist in 20 horizontale Reihen (R1 - R20) und 24 vertikale Spalten (S1 - S24) aufgeteilt. Die Anzahl der Reihen und Spalten wird in einer tatsächlichen Anwendung bei weitem größer sein. Vier benachbarte Reihen (R1 - R4; R5 - R8; R9 - R12; usw.) bilden jeweils ein Segment (SE1, SE2, SE3, usw.). In den Segmenten ist jeweils jede vierte Kontaktstelle einer Reihe mit einem Scankanal verbunden. In den Segmenten sind Kontaktstellen 2 der einzelnen Reihen mit demselben Scankanal verbunden, wobei die mit einem Scankanal verbundenen Kontaktstellen zweier benachbarter Reihen vorzugsweise diagonal an der Grundrasterplatte angeordnet sind. Bei dem in Fig. 5 dargestellten Ausführungsbeispiel sind pro Segment vier Scankanäle vorgesehen. Im ersten Segment sind mit dem ersten der Scankanäle die Kontaktstellen 1, mit dem zweiten Scankanal die Kontaktstellen 2, mit dem dritten Scankanal die Kontaktstellen 3 und mit dem vierten Scankanal die Kontaktstellen 4 verbunden. Die Scankanäle weisen elektrische Verbindungen zu Kontaktstellen 2 aus mehreren Reihen auf, wobei die mit einem Scankanal verbundenen Kontaktstellen 2 von benachbarten Reihen oder Spalten vorzugsweise zueinander versetzt angeordnet sind. Da die Scankanäle mit Kontaktstellen aus mehreren Reihen verbunden sind, wird die Anzahl der Scankanäle weiter reduziert.

Die Scankanäle 10 zwischen den einzelnen Lagen 6 in ~ der Grundrasterplatte 3 können in der Draufsicht auf die Grundrasterplatte 3 in unterschiedlichen Richtungen angeordnet und insbesondere senkrecht zueinander angeordnet sein, wodurch eine örtliche Selektivität erzielt wird.

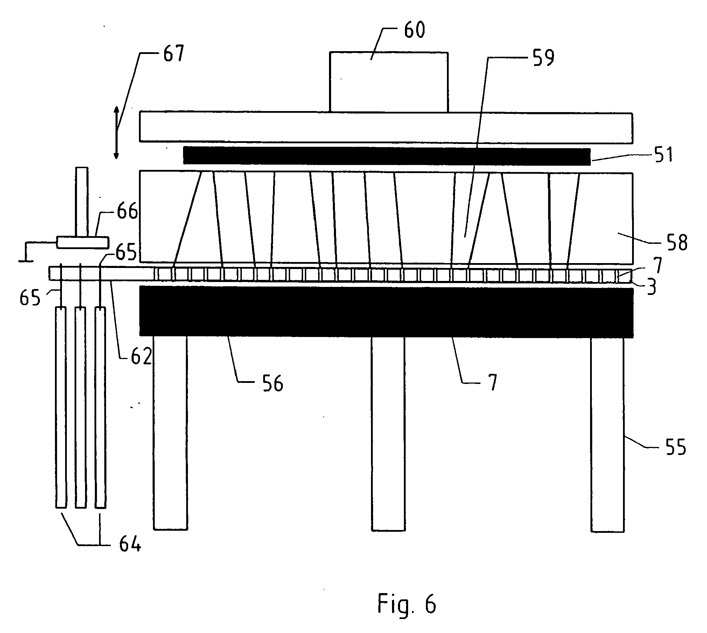

In Fig. 6 ist schematisch vereinfacht eine Vorrichtung 50 zum Prüfen unbestückter Leiterplatten 51 dargestellt.

Dieses Vorrichtung weist einen massiven Tisch 55 mit einer Tischplatte 56 auf. Die Tischplatte 56 ist isoliert und auf ihr lagert eine erfindungsgemäße Grundrasterplatte 3. Auf der Grundrasterplatte 3 ist ein Adapter 58 mit Nadeln 59, insbesondere Starrnadel, angeordnet. Die Nadeln 59 können zur Auswahl eines bestimmten Scankanals in der oben beschriebenen Art und Weise schräggestellt sein. Auf dem Adapter 58 lagert die zu prüfende Leiterplatte 51, welche mittels eines Stempels 60 gegen den Adapter gedruckt wird.

Die Grundrasterplatte 3 weist einen über die Tischplatte 56 vorstehenden Anschlußbereich 62 auf, in den die Scankanäle (nicht dargestellt) verlängert sind. An diesem Anschlußbereich 62 sind an der Unterseite Einheiten 64 der Auswerteelektronik angeordnet und elektrisch mit den Scankanälen mittels Kontaktstiften 65 oder dergleichen verbunden. Diese Kontaktstifte 65 erstrecken sich vertikal durch die Grundrasterplatte 3 und stehen an deren Oberseite vor. Oberhalb des Anschlußbereichs 62 ist eine elektrisch leitende Platte 66 parallel zur Grundrasterplatte 3 angeordnet, und vertikal in Doppelpfeilrichtung 67 verschieblich gelagert. Die Platte 66 ist geerdet.

Dieser Anschlußbereich 62 bildet zusammen mit der elektrisch geerdeten Platte 66 eine Erdungseinrichtung, die es erlaubt, vor und nach einem Meßvorgang, die in der Leiterplatte 51 und/oder in der Meßeinrichtung (Grundrasterplatte, Adapter, Auswerteelektronik, usw.) befindlichen elektrischen Potentiale durch Kontaktierung der Platte 66 mit den nach oben vorstehenden Kontaktstiften 65 abzuleiten. Hierdurch können zum einen sehr schnell definierte elektrische Verhältnisse geschaffen werden und die Pausen zwischen den einzelnen Meßvorgängen, die zum Ableiten der elektrischen Potentiale bei herkömmlichen Prüfvorrichtungen notwendig sind, erheblich vermindert werden. Anstelle der nach oben vorstehenden Kontaktstifte 65 können auch an anderer Stelle der Grundrasterplatte frei liegende Kontaktpunkte vorgesehen sein, die mit den Scankanälen und somit mit der Auswerteelektronik und der zu prüfenden Leiterplatte elektrisch verbunden sind. Durch Berühren der Kontaktpunkte mit einem geerdeten Leiter wird die zu prüfende Leiterplatte und die Auswerteelektronik geerdet.

Bei dieser Prüfvorrichtung 50 wird der erhebliche, vom Stempel 60 ausgeübte Prüfdruck über den massiven Tisch 55 abgleitet. Herkömmliche Prüfvorrichtungen weisen in der Regel unterhalb der Grundrasterplatte Einheiten der Auswerteelektronik auf, so daß ein erheblicher konstruktiver Aufwand notwendig ist, um den Prüfdruck über die Elektronikeinheiten oder an diesen vorbei abzuleiten.

Anstelle des Tisches 55 kann selbstverständlich ein Sockel oder dergleichen vorgesehen werden; es muß lediglich eine stabile Auflage für die Grundrasterplatte 3 geschaffen werden.

## Patentansprüche

1. Prüfvorrichtung zum Prüfen von unbestückten Leiterplatten, mit einer Auswerteelektronik, welche elektrisch mit einem Grundraster (1) verbunden ist, wobei auf dem Grundraster (1) ein Adapter (38) und/oder ein Translator lagert, eine zu prüfende Leiterplatte darauf aufgelegt werden kann, wobei der Adapter (32) und/oder Translator (30) einen elektrischen Kontakt von auf der Leiterplatte befindlichen Leiterplattentestpunkten zu Kontaktstellen (2) des Grundrasters (1) herstellt, wobei
das Grundraster (1) auf der Oberfläche einer Grundrasterplatte (3) ausgebildet ist, und zumindest zwei Kontaktstellen (2) des Grundrasters (1) miteinander in der Grundrasterplatte (3) elektrisch verbunden sind, und die Kontaktstellen (2) zumindest bereichsweise einen Mittenabstand (a) von 800 µm oder weniger aufweisen,
sich von den Kontaktstellen (2) senkrecht nach unten durch die einzelnen Lagen (4, 6) der Grundrasterplatte (3) Durchkontaktierungen (7) erstrecken, und
die Durchkontaktierungen (7) und die Kontaktstellen (2) in mehreren Reihen angeordnet sind und zwischen den Reihen von Durchkontaktierungen Scankanäle (10) verlaufen, wobei die Durchkontaktierungen (7) jeweils über eine Stichleitung (11) mit einem einzelnen der Scankanäle (10) elektrisch verbunden sind,
wobei die Grundrasterplatte (3) als laminierte Leiterplatte mit einer oberen und unteren Begrenzungslage (4, 5) und Zwischenlagen (6) ausgebildet ist,
zwischen zwei Zwischenlagen (6) im Bereich zwischen zwei Reihen von Durchkontaktierungen jeweils ein Paar Scankanäle (10) angeordnet ist, wobei jeder Scankanal der benachbarten Reihe von Durchkontaktierungen zugeordnet ist.

2. Prüfvorrichtung nach Anspruch 1,
**dadurch gekennzeichnet,**
**dass** die Kontaktstellen (2) in einem regelmäßigen Raster angeordnet sind.

3. Prüfvorrichtung nach Anspruch 1 oder 2,
**dadurch gekennzeichnet,**
**dass** die Kontaktstellen (2) einen Mittenabstand (a) von 50 µm bis 630 µm

4. Prüfvorrichtung nach Anspruch 1 oder 2,
**dadurch gekennzeichnet,**
**dass** die Kontaktstellen (2) einen Mittenabstand (a) von 300 µm bis 500 µm aufweisen.

5. Prüfvorrichtung nach einem der Ansprüche 1 bis 4,
**dadurch gekennzeichnet,**
**dass** jede x-te Kontaktstelle (2) einer Reihe von Kontaktstellen (2) mit dem gleichen Scankanal (10) elektrisch verbunden ist, wobei x eine ganze Zahl zwischen 3 und 100 und vorzugsweise zwischen 20 und 40 ist.

6. Prüfvorrichtung nach einem der Ansprüche 1 bis 5,
**dadurch gekennzeichnet,**
**dass** eine elektrische Schnittstelle seitlich an der Grundrasterplatte (3) zum Kontaktieren der Auswerteelektronik angeordnet ist.

7. Prüfvorrichtung nach Anspruch 6,
**dadurch gekennzeichnet,**
**dass** die elektrische Schnittstelle als Steckverbinder ausgebildet ist

8. Prüfvorrichtung nach einem der Ansprüche 1 bis 7,
**dadurch gekennzeichnet,**
**dass** die Grundrasterplatte (3) mechanisch in zumindest zwei Teilplatten aufgeteilt ist.

9. Prüfvorrichtung nach einem der Ansprüche 1 bis 8,
**dadurch gekennzeichnet,**
**dass** das Grundraster (1) in zumindest zwei voneinander getrennte Bereiche (16, 17) aufgeteilt ist, wobei keine Kontaktstelle (2) des einen der beiden Bereiche (16, 17) mit einer Kontaktstelle (2) des anderen der Bereiche (16, 17) elektrisch verbunden ist.

10. Prüfvorrichtung nach Anspruch 9,
**dadurch gekennzeichnet,**
**dass** das Grundraster (1) in der Draufsicht eine rechteckige Form aufweist und durch eine diagonal verlaufende Trennlinie (18) in die beiden Bereiche (16, 17) unterteilt ist.

11. Prüfvorrichtung nach Anspruch 9 oder 10,
**dadurch gekennzeichnet,**
**dass** das Grundraster (1) in zumindest vier voneinander getrennte Bereiche (19, 20, 21, 22) aufgeteilt ist, wobei keine Kontaktstelle (2) des einen der vier Bereiche (19, 20, 21, 22) mit einer Kontaktstelle (2) eines der drei anderen Bereiche (19, 20, 21, 22) elektrisch verbunden ist.

12. Prüfvorrichtung nach einem der Ansprüche 1 bis 11,
**dadurch gekennzeichnet,**
**dass** der Adapter (32) Nadeln aufweist, die auf jeweils einer Kontaktstelle (2) enden, wobei zumindest eine Nadel schräg gegenüber einer auf dem Grundraster senkrecht stehenden Linie angeordnet ist.

13. Prüfvorrichtung nach einem der Ansprüche 1 bis 12,
**dadurch gekennzeichnet,**
**dass** Gruppen von zumindest drei oder mehrere Kontaktstellen (2) elektrisch miteinander verbunden sind.

14. Prüfvorrichtung nach einem der Ansprüche 1 bis 13,
**dadurch gekennzeichnet,**
**dass** das Translatorboard (30) Leiterbahnen (40) aufweist, die die Leiterplattentestpunkte mit den Kontaktstellen (2) elektrisch verbinden, wobei die Leiterbahnen (40) so ausgebildet sind, dass kein Scankanal (10) mit mehr als einem der Leiterplattentestpunkte verbunden ist.

15. Prüfvorrichtung nach Anspruch 14,
**dadurch gekennzeichnet,**
**dass** ein Translatorboard (30) vorgesehen ist, der an einer Oberfläche Kontaktflächen (41o) aufweist, die jeweils einem Leiterplattentestpunkt zugeordnet sind, und auf der gegenüberliegenden Oberfläche Kontaktflächen (41 u) aufweist, die jeweils einem Testanschluss zugeordnet sind.

16. Prüfvorrichtung nach einem der Ansprüche 1 bis 15,
**dadurch gekennzeichnet,**
**dass** die Grundrasterplatte (3) einen sich über den auf einer Auflage (56) aufliegenden Bereich der Kontaktstellen (2) hinaus erstreckenden Anschlussbereich (62) aufweist, an dem Einheiten (64) der Auswerteelektronik angeschlossen sind.

17. Prüfvorrichtung nach einem oder mehreren der Ansprüche 1 bis 16,
**dadurch gekennzeichnet,**
**dass** das Grundraster (1) außerhalb eines einer zu prüfenden Leiterplatte zugeordneten Prüfbereichs des Grundrasters (1) frei liegende Kontaktpunkte aufweist, so dass durch Berührung dieser Kontaktstellen mit einem geerdeten elektrischen Leiter (66) die Auswerteelektronik und/oder die zu prüfende Leiterplatte geerdet werden können.

18. Prüfvorrichtung nach Anspruch 17,
**dadurch gekennzeichnet,**
**dass** eine das Grundraster (1) tragende Grundrasterplatte (3) sich über den auf einer Auflage (56) aufliegenden Bereich der Kontaktstellen (2) hinaus erstreckenden Anschlussbereich (62) aufweist, an dem Einheiten (64) der Auswerteelektronik angeschlossen sind, wobei die Anschlusskontakte an der zu den jeweiligen Einheiten (64) der Auswerteelektronik gegenüberliegenden Seite der Grundrasterplatte (3) frei liegen, und die Kontaktpunkte zum Erden der zu prüfenden Leiterplatte und/oder der Auswerteelektronik bilden.

19. Prüfvorrichtung nach Anspruch 18,
**dadurch gekennzeichnet,**
**dass** die Einheiten (64) der Auswerteelektronik lediglich an einer Seite der Grundrasterplatte (3) angeordnet sind.

20. Verwendung einer Prüfvorrichtung nach einem der Ansprüche 1 bis 19,
**dadurch gekennzeichnet,**
**dass** die zu testende Leiterplatte so auf der Prüfvorrichtung angeordnet wird, dass mit einem jeden Scankanal (10) höchstens nur ein Leiterplattentestpunkt elektrisch verbunden wird.

## Claims

1. Test apparatus for testing non-componented printed circuit boards, comprising an electronic analyzer electrically connected to a grid pattern (1), whereon an adapter (38) and/or translator is mounted, on which a circuit board to be tested can be placed, said adapter (32) and/or translator (30) producing an electrical contact from the circuit board test points on said circuit board to contact points (2) of said grid pattern (1),
wherein the grid pattern (1) is configured on the surface of a grid base (3), at least two contact points (2) of said grid pattern (1) being electrically connected to each other In said grid base (3), and said contact points (2) comprise at least in some portions a center-spacing (a) of 800 µm or less,
wherein feed-through contacts (7) extend from said contact points (2) vertically downwards through individual layers (4, 6), and
wherein said feed-through contacts (7) and said contact points (2) are arranged in several rows and scanning channels (10) are oriented between the rows of feed-through contacts (7), each of said feed-through contacts being electrically connected to a single scanning channel (10) via a branch line (11),
wherein said grid base (3) is configured as a laminated circuit board with an upper and a lower limiting layer (4, 5) and inner layers (6),
between two inner layers (6) in the portion between two rows of feed-through contacts respectively a pair of scanning channels (10) is configured,
wherein each scanning channel is assigned to the adjacent row of feed-through contacts.

2. Test apparatus as set forth in claim 1,
**characterised in that**
said contact points (2) are arranged in a regular grid pattern.

3. Test apparatus as set forth in claim 1 or 2,
**characterised in that**
said contact points (2) have a center-spacing (a) of 50 µm to 630 µm.

4. Test apparatus as set forth in claim 1 or 2,
**characterised in that**
the contact points (2) have a center-spacing (a) of 300 µm to 500 µm.

5. Test apparatus as set forth in one of the claims 1 to 4,
**characterised in that**
each x^{th} contact point (2) of a row of contact points (2) is electrically connected to the same scanning channel (10), where x is a whole number between 3 and 100 and preferably between 20 and 40.

6. Test apparatus as set forth in one of the claims 1 to 5,
**characterised in that**
an electrical interface is arranged on said side of said grid base (3) for contacting said electronic analyzer.

7. Test apparatus as set forth in claim 6,
**characterised in that**
said electrical interface is configured as a connector.

8. Test apparatus as set forth in one of the claims 1 to 7,
**characterised in that**
said grid base (3) is divided mechanically into at least two partial boards.

9. Test apparatus as set forth in one of the claims 1 to 8,
**characterised in that**
said grid pattern (1) is divided into at least two portions (16, 17) separate from each other, no contact point (2) of one portion being electrically connected to a contact point (2) of the other portion (16, 17).

10. Test apparatus as set forth in claim 9,
**characterised in that**
said grid pattern (1) is rectangular in shape, as viewed from above, and is divided into the two portions (16, 17) by a diagonally oriented parting line (18).

11. Test apparatus as set forth in one of the claims 9 or 10,
**characterised in that**
said grid pattern (1) is divided into at least four portions separate from each other (19, 20, 21, 22), no contact point (2) of any one portion (19, 20, 21, 22) of said four being electrically connected to a contact point (2) of one of said other three portions (19, 20, 21, 22).

12. Test apparatus as set forth in one of the claims 1 to 11,
**characterised in that**
said adapter (32) comprises probes, each of which ends in a contact point (2), at least one probe being arranged tilted relative to a line standing perpendicular to said grid pattern.

13. Test apparatus as set forth in claim 1 to 12,
**characterised in that**
groups of at least three or more contact points (2) are electrically connected to each other.

14. Test apparatus as set forth in one of the claims 1 to 13,
**characterised in that**
said translator board (30) comprises conductor paths (40) electrically connecting said circuit board test points to said contact points (2), said conductor paths (40) being configured so that no scanning channel (10) is connected to more than one of said circuit board test points.

15. Test apparatus as set forth in claim 14,
**characterised in that**
said translator board (30) is comprising on its surface contact pads (410), each assigned to a circuit board test point, and comprising on said opposite surface contact pads (41 u), each assigned to a test connection.

16. Test apparatus as set forth in one of the claims 1 to 15,
**characterised in that**
said grid base (3) comprises a connection portion (56) extending beyond said portion (62) of said contact points (2) resting on a mount, units (64) of said electronic analyzer being connected to said connection portion.

17. Test apparatus for testing non-componented circuit boards according to one or more of the claims 1 to 16,
**characterised in that**
said grid pattern (1) comprises exposed contact points outside of a test portion of said grid pattern (1) assigned to a circuit board under test so that by bringing these contact points into contact with a grounded electrical conductor (66) said electronic analyzer and/or said said circuit board under test can be grounded.

18. Test apparatus as set forth in claim 17,
**characterised in that**
a grid base (3) carrying said grid pattern (1) comprises a connection portion (56) extending beyond said portion (62) of said contact points resting on a mount, units (64) of said electronic analyzer being connected to said connection portion, said connecting contacts being exposed at the side of said grid base (3) opposite said corresponding units (64) of said electronic analyzer, and forming said contact points for grounding said board under test and/or said electronic analyzer.

19. Test apparatus as set forth in claim 18,
**characterised in that**
said units (64) of said electronic analyzer are arranged on one side of said grid base (3) only.

20. Use of a test apparatus as set forth in one of the claims 1 to 19,
**characterised in that**
said circuit board under test is arranged on said test apparatus so that one circuit board test point at the most is electrically connected to each scanning channel (10).

## Revendications

1. Appareil de test pour tester des cartes à circuits imprimés non garnies, comprenant une unité électronique d'évaluation, reliée de manière électrique avec une trame de base (1), un adaptateur (38) et/ou un convertisseur étant posé sur la trame de base (1), une carte à circuits imprimés à tester peut être posée sur celui-ci, ledit adaptateur (32) et/ou convertisseur (30) établissant un contact électrique entre des points de tests de carte qui se trouvent sur la carte à circuits imprimés et des emplacements de contact (2) de la trame de base (1), dans lequel :
la trame de base (1) est réalisée sur la surface d'une plaque de trame de base (3) et au moins deux emplacements de contact (2) de la trame de base (1) sont reliés l'un à l'autre de façon électrique dans la plaque de trame de base (3), et les emplacements de contact (2) présentent au moins par zone une distance moyenne (a) de 800 µm ou moins,
des trous de contact (7) s'étendent depuis les emplacements de contact (2) verticalement vers le bas à travers les couches individuelles (4, 6) de la plaque de trame de base (3), et
les trous de contact (7) et les emplacements de contact (2) sont agencés en plusieurs rangées, et entre les rangées de trous de contact s'étendent des canaux de balayage (10), les trous de contact (7) étant reliés chacun via une ligne de branchement (11) à un unique canal de balayage (10),
la plaque de trame de base (3) est réalisée sous la forme d'une carte à circuits imprimés stratifiée avec une couche de délimitation supérieure et une couche de délimitation inférieure (4, 5) et des couches intermédiaires (6), et
entre deux couches intermédiaires (6) dans la région entre deux rangées de trous de contact est agencée une paire respective de canaux de balayage (10), chaque canal de balayage étant associé à la rangée voisine de trous de contact.

2. Appareil de test selon la revendication 1, **caractérisé en ce que** les emplacements de contact (2) sont agencés dans une trame régulière.

3. Appareil de test selon la revendication 1 ou 2, **caractérisé en ce que** les emplacements de contact (2) présentent une distance moyenne (a) de 50 µm à 630 µm.

4. Appareil de test selon la revendication 1 ou 2, **caractérisé en ce que** les emplacements de contact (2) présentent une distance moyenne (a) de 300 µm à 500 µm.

5. Appareil de test selon l'une des revendications 1 à 4, **caractérisé en ce que** chaque x-ième emplacement de contact (2) d'une rangée d'emplacements de contact (2) est relié électriquement au même canal de balayage (10), x étant un nombre entier entre 3 et 100, et de préférence entre 20 et 40.

6. Appareil de test selon l'une des revendications 1 à 5, **caractérisé en ce qu'**une interface électrique est agencée latéralement sur la plaque de trame de base (3) pour la mise en contact de l'unité électronique d'évaluation.

7. Appareil de test selon la revendication 6, **caractérisé en ce que** l'interface électrique est réalisée sous la forme de jonction à enfichage.

8. Appareil de test selon l'une des revendications 1 à 7, **caractérisé en ce que** la plaque de trame de base (3) est subdivisée mécaniquement en au moins deux plaques partielles.

9. Appareil de test selon l'une des revendications 1 à 8, **caractérisé en ce que** la trame de base (1) est subdivisée en au moins deux régions (16, 17) séparées l'une de l'autre, aucun emplacement de contact (2) de l'une des deux régions (16, 17) n'étant relié électriquement à un emplacement de contact (2) de l'autre des régions (16, 17).

10. Appareil de test selon la revendication 9, **caractérisé en ce que** la trame de base (1) présente en vue de dessus une forme rectangulaire et est subdivisée pour former les deux régions (16, 17) par une ligne de séparation (18) qui s'étend en diagonale.

11. Appareil de test selon la revendication 9 ou 10, **caractérisé en ce que** la trame de base (1) est subdivisée en au moins quatre régions (19, 20, 21, 22) séparées les unes des autres, aucun emplacement de contact (2) de l'une des quatre régions (19, 20, 21, 22) n'étant relié électriquement à un emplacement de contact (2) de l'une des trois autres régions (19, 20, 21, 22).

12. Appareil de test selon l'une des revendications 1 à 11, **caractérisé en ce que** l'adaptateur (32) présente des aiguilles qui se terminent sur un emplacement de contact respectif (2), au moins une aiguille étant agencée en oblique vis-à-vis d'une ligne dressée perpendiculairement sur la trame de base.

13. Appareil de test selon l'une des revendications 1 à 12,
**caractérisé en ce que** des groupes d'au moins trois ou plusieurs emplacements de contact (2) sont reliés électriquement les uns aux autres.

14. Appareil de test selon l'une des revendications 1 à 13, **caractérisé en ce que** la carte de conversion (30) comporte des pistes conductrices (40) qui relient les points de test de la carte de circuits électriquement avec les emplacements de contact (2), et les pistes conductrices (40) sont réalisées de telle manière qu'aucun canal de balayage (10) n'est relié à plus d'un point de test de carte à circuits imprimés.

15. Appareil de test selon la revendication 14, **caractérisé en ce qu'**il est prévu une carte de conversion (30) qui présente sur une surface des surfaces de contact (41o) associées respectivement à un point de test de carte à circuits imprimés, et qui présente sur la surface opposée des surfaces de contact (41u) associées respectivement à un raccord de test.

16. Appareil de test selon l'une des revendications 1 à 15, **caractérisé en ce que** la plaque de trame de base (3) présente une zone de raccordement (62) qui s'étend au-delà de la région des emplacements de contact (2) qui repose sur un appui (56), ladite zone de raccordement (62) étant reliée aux unités (64) de l'unité électronique d'évaluation.

17. Appareil de test selon l'une ou plusieurs des revendications 1 à 16, **caractérisé en ce que** la trame de base (1) présente, à l'extérieur d'une zone de test, associée à la plaque à circuit imprimé à tester, de la trame de base (1), des points de contact disposés de manière libre, de sorte qu'en touchant ces emplacements de contact avec un conducteur électrique mis à la terre (66), l'unité électronique d'évaluation et/ou la carte à circuits imprimés à tester peut être mise à la terre.

18. Appareil de test selon la revendication 17, **caractérisé en ce que** une plaque de trame de base (3) qui porte la trame de base (1) présente une zone de raccordement (62) qui s'étend au-delà de la zone des emplacements de contact (2) qui repose sur un appui (56), zone de raccordement à laquelle sont raccordées des unités (64) de l'unité électronique d'évaluation, et les contacts de raccordement sont disposés librement sur le côté de la plaque de trame de base (3) opposé aux unités respectives (64) de l'unité électronique d'évaluation, et forment les points de contact pour la mise à la terre de la carte à circuits imprimés à tester et/ou de l'unité électronique d'évaluation.

19. Appareil de test selon la revendication 18, **caractérisé en ce que** les unités (64) de l'unité électronique d'évaluation sont agencées sur un côté seulement de la plaque de trame de base (3).

20. Utilisation d'un appareil de test selon l'une des revendications 1 à 19, **caractérisée en ce que** la carte à circuits imprimés à tester est agencée sur l'appareil de test de telle façon qu'un point de test de carte à circuits imprimés au maximum est relié électriquement à chaque canal de balayage (10).
